# EUROPEAN PATENT APPLICATION

(11) **EP 2 226 832 A1**
(43) Date of publication of application: **08.09.2010**
(21) Application number: 09154514.5
(22) Date of filing: 06.03.2009
(51) Int. Cl.: H01J 37/32

(54) **Substrate plasma treatment using side tabs**

(71) Applicant: FUJIFILM Manufacturing Europe B.V., 5047 TK Tilburg (NL)
(72) Inventor: De Vries, Hindrik Willem, 5045 CM, Tilburg (NL)
(74) Representative: Ketelaars, Maarten F.J.M.

(57) **Abstract**

Method and plasma treatment apparatus for treatment of a surface of a substrate. A dielectric barrier discharge electrode structure is provided having a treatment space (5) in between a first electrode (2) and a second electrode (3). A power supply (4) connected to the first electrode (2) and the second electrode (3) is provided for generating an atmospheric pressure plasma in the treatment space (5). At least one side tab (6; 6a, 6b) is provided in contact with an edge (11; 11a, 11b) of the first electrode (2) and an edge (12; 12a, 12b) of the second electrode (3), the at least one side tab (6; 6a, 6b) sealing off at least a part of the treatment space (5).

## Description

### Field of the invention

The present invention relates to a plasma treatment apparatus for treatment of a surface of a substrate, comprising a dielectric barrier discharge electrode structure having a treatment space in between a first electrode and a second electrode, and a power supply connected to the first electrode and the second electrode for generating an atmospheric pressure plasma in the treatment space. In a further aspect, the present invention relates to a method for treatment of a substrate surface using atmospheric pressure plasma, the method comprising providing a dielectric barrier discharge electrode structure for generating an atmospheric pressure plasma in a treatment space between a first electrode and a second electrode, providing a substrate in the treatment space, and applying a plasma generating power to the first and second electrode.

### Prior art

JP-A-2008053367 is describing a plasma-processing apparatus having a gas supply input comprising several nozzles supplying a plasma gas and a shielding gas towards processing and non-processing region sides of the substrate, respectively.

JP-A-2004296460 is describing a plasma-processing apparatus for processing substrate with a insulation protection component provided at the vacuum seal surface side of a metal chamber wall and another chamber wall.

### Summary of the invention

The present invention seeks to provide an improved plasma treatment method and apparatus and the use of the method and apparatus for treatment of the surface of a substrate using a plasma.

According to the present invention, a plasma treatment apparatus according to the preamble defined above is provided, further comprising at least one side tab in contact with an edge of the first electrode and an edge of the second electrode, the at least one side tab sealing off at least a part of the treatment space. The use of the at least one side tab allows more stable gas-flow and more stable plasmas and avoids useless consumption of plasma gas by leaking out through the side of the treatment space between the electrodes. Furthermore, it has been found that deposition rates (DR) are increased significantly.

In an embodiment, the at least one side tab protrudes into the treatment space. The interaction between the at least one side tab and the electrodes is such that there is still room available for a substrate to move across the gap between the two opposing electrodes without being in contact with the side tab. This ensures that the substrate is not being damaged for example by scratching due to direct contact between side tab and substrate

The treatment space is a rectangular space in a further embodiment, and the at least one side tab is positioned along at least one side of the treatment space. This shielding off already provides improvement in efficient use of the generated plasma.

The at least one side tab is in a further embodiment provided at a side of the treatment space opposing a gas supply inlet for providing a gas mixture into the treatment space. This aids in steering the gas stream in the treatment space in an optimal manner.

In an even further embodiment, the at least one side tab comprises two side tabs provided at two opposing sides of the treatment space. This provides an excellent shielding of the treatment space, and also allows to use a moving substrate, e.g. in the form of a moving web or foil.

The two side tabs are connected by a gas supply inlet for providing a gas mixture into the treatment space in a further embodiment, which allows to use as little number of parts in the plasma treatment apparatus as possible.

The at least one side tab comprises a non-conductive material, such as glass, wood, ceramic or a polymer material, such as PE, PEN, PET. This allows easy and cost-efficient manufacturing of this combined part.

In a further aspect, the present invention relates to a method as defined in the preamble above, further comprising providing at least one side tab in contact with an edge of the first electrode and an edge of the second electrode, the at least one side tab sealing off at least a part of the treatment space.

In a further embodiment, the substrate is moved through the treatment space, e.g. in a roll-to-roll arrangement for treating a web or foil.

Two substrates are moved simultaneously through the treatment space in a further embodiment, e.g. acting as (part of) the dielectric layer in the dielectric barrier discharge (DBD) electrode configuration. This allows treatment of two substrates at the same time, improving efficiency of the method.

The substrate treatment comprises a chemical or physical surface treatment, a cleaning surface treatment or a surface deposition treatment.

In an even further aspect, the present invention relates to the use of the method according to any one of the embodiments described above, the use of the apparatus according to any of the apparatus embodiments described above, in order to obtain a treated substrate.

### Short description of drawings

The present invention will be discussed in more detail below, using a number of exemplary embodiments, with reference to the attached drawings, in which
Fig. 1 shows a cross sectional view of a first embodiment of a plasma treatment apparatus according to a first embodiment of the present invention;
Fig. 2 shows a cross sectional view of a second embodiment of a plasma treatment apparatus according to the present invention;
Fig. 2a shows a schematic example of an embodiment having the side tabs connected into the gap via the gas supply;
Fig. 2b shows a top view of the plasma treatment apparatus of Fig. 2;
Fig. 3 shows a cross sectional view of an example of a third embodiment of a plasma treatment apparatus according to the present invention;
Fig. 4 shows a schematic example of an embodiment of a plasma treatment apparatus using two substrates and side tabs;
Fig. 5 shows a schematic view of an electrode configuration used in the plasma treatment apparatus of Fig. 1 according to an embodiment of the present invention; and
Fig. 6 shows a plot of the DR that may be achieved for various embodiments and comparative examples of the present invention.

### Detailed description of exemplary embodiments

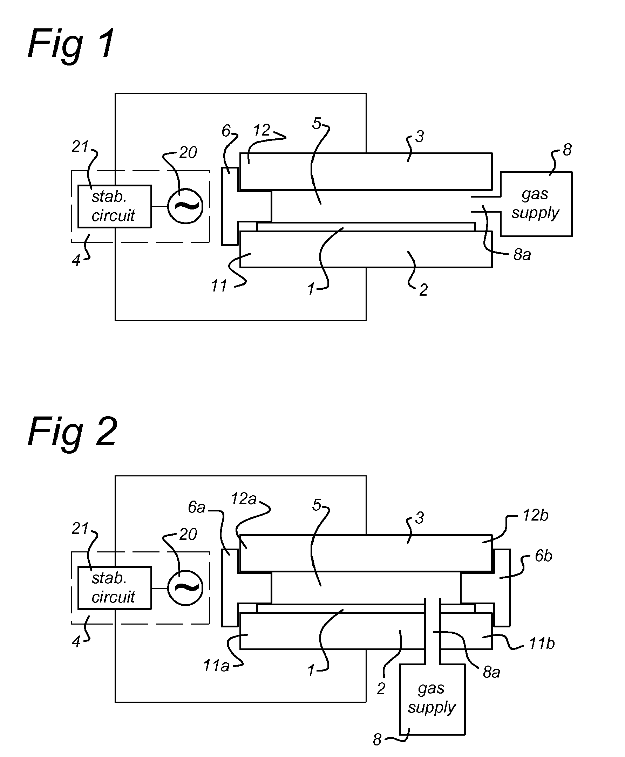

In embodiments of the present invention a dielectric barrier discharge (DBD) electrode structure (geometry) is used in which atmospheric pressure plasma is generated, such as an atmospheric pressure glow discharge plasma. A cross sectional view of the configuration of a first embodiment of the present invention is shown in Fig. 1. A first electrode 2 and second electrode 3 are provided, forming a treatment space 5 in between the electrodes 2, 3 in the form of a gap. In the embodiment shown, the electrodes 2, 3 are planar electrodes, and the treatment space 5 is a rectangular space. However, other forms of the electrodes 2, 3 and of the gap or treatment space 5 are possible, e.g. as part of a cylindrical arrangement of the plasma treatment apparatus. E.g., the treatment space may be cylindrical, or elliptic, or have another form adapted to treat a specific type of substrate 1.

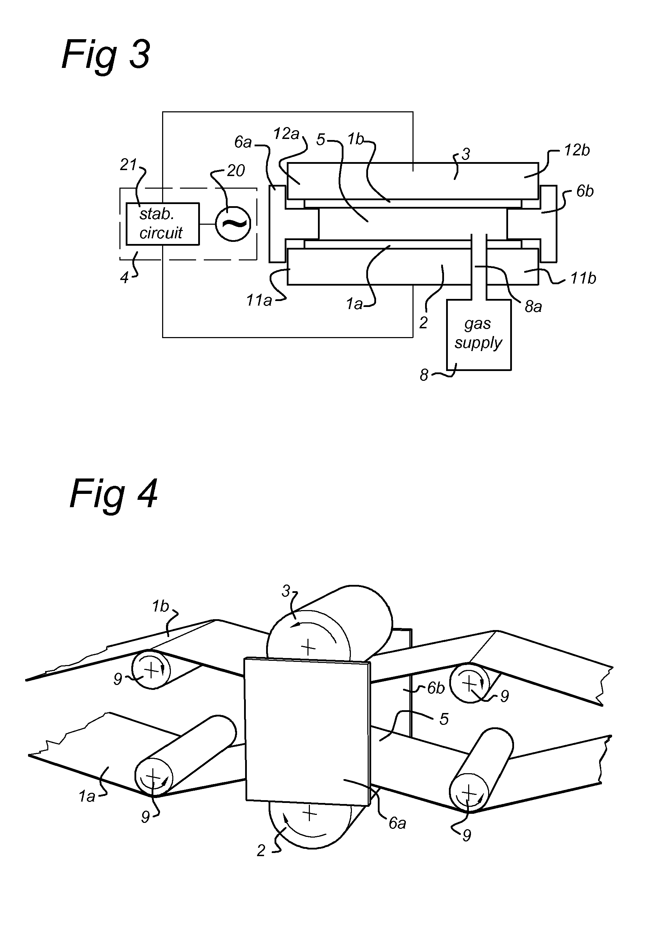

Both electrodes 2, 3 may have the same configuration being flat orientated (as shown in Fig. 1) or both being roll-electrodes (as shown e.g. in the embodiment of Fig. 4, see below). Also different configurations may be applied using a roll electrode 2 and a flat or cylinder segment shaped electrode 3 opposing each other. In further embodiments, the electrodes 2, 3 may be multi-segment electrodes.

A roll-electrode 2, 3 is e.g. implemented as a cylinder shaped electrode, mounted to allow rotation in operation e.g. using a mounting shaft or bearings. The roll-electrode 2, 3 may be freely rotating, or may be driven at a certain angular speed, e.g. using well known controller and drive units.

As shown in Fig. 1, the electrodes 2, 3 are connected to a power supply 4, which is arranged to provide electrical power to the electrodes 2, 3 for generating the glow discharge plasma under an atmospheric pressure in the treatment space 5 having a controlled energy supply. The electrodes 2, 3 are connected to a power supply 4 which is arranged to provide electrical power to the electrodes 2, 3 for generating the glow discharge plasma under an atmospheric pressure in the treatment space 5. The power supply 4 comprises an AC power source 20 connected to a stabilisation circuit 21. The stabilisation circuit 21 is arranged to be able to generate an atmospheric pressure glow discharge plasma in the treatment space 5.

In the plasma treatment apparatus a gas supply device 8 is arranged for the substrate treatment in order to direct gas towards an inner region of the substrate 1 to be processed, as shown in Fig. 1, a gas supply inlet 8a is used to direct the gas into the treatment space 5. In case a deposition application is considered the gas supply will comprise at least one precursor. The gas supply device 8 may be provided with storage, supply and mixing components as known to the skilled person. The gases used may vary depending on the intended application. The gasses can be selected for example from noble gases like argon and the like, an inert gas like nitrogen, reactive gases like oxygen, hydrogen, carbon(di)oxide, nitrogen-oxide combinations of these reactive gases and inert or noble gases and a precursor in case of deposition applications. In case of the use of a precursor it is the purpose to have the precursor decomposed in the treatment space or gap 5 to a chemical compound or chemical element which is deposited on the substrate 1.

According to the present invention, at least one side tab 6 is arranged in the treatment space 5 for shielding the supply of gas towards the non-processing outer region side of the substrate 1 and directing the plasma to the processing region of substrate 1. The at least one side tab 6 is in contact with an edge 11 of the first electrode 2 and an edge 12 of the second electrode 3, thus sealing off at least part of the treatment space 5. In the embodiment shown in Fig. 1, the treatment space is a rectangular space, and the at least one side tab is positioned along at least one side of the treatment space 5.

In a further embodiment, the at least one side tab 6 protrudes into the treatment space 5. The protruding part of the at least one side tab 6 may be arranged to direct the supply of gas in a predetermined manner, e.g. deflecting it towards the surface of the substrate 1. To enhance this effect, the at least one side tab 6 is provided at a side of the treatment space 5 opposing a gas supply inlet 8a for providing a gas mixture into the treatment space 5.

According to an embodiment of the present invention, a side tab 6 of a non-conductive material or insulator is installed in close proximity to the substrate 1, however not in direct contact with the substrate 1 in order to avoid damages such as scratching when the substrate 1 is moved through the treatment space 5. Examples of non-conductive materials include but are not limited to glass, wood, ceramic or polymers such as i.e. PE, PET or PEN.

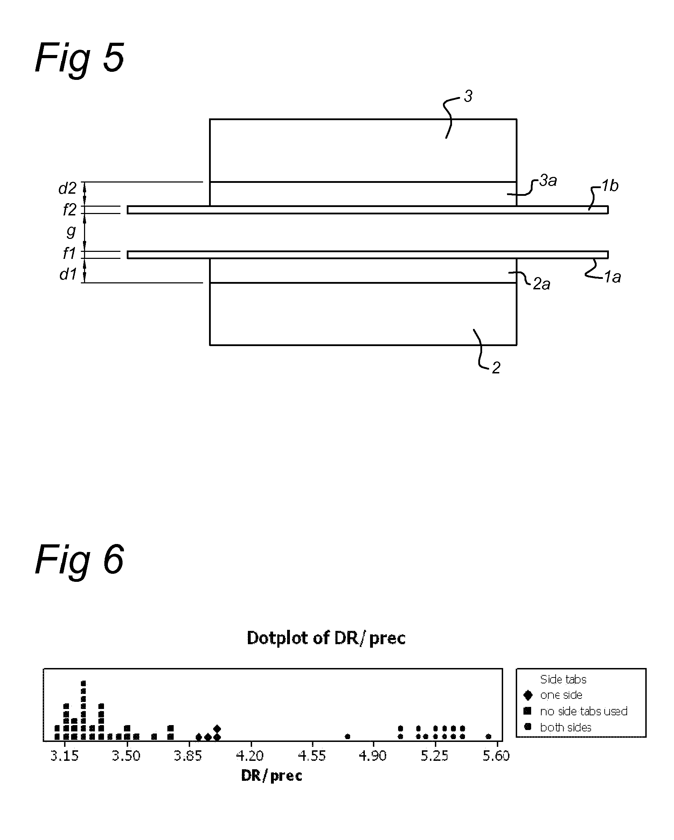

Dimensions of the side tab 6 is chosen to allow the moving of substrate 1 or substrates 1a and 1b through the treatment space 5 without causing damages to the substrate(s). In other words the total thicknesses of the non-conductive material of the side tab 6 between electrodes 2, 3 and substrates 1 should be less than the free inter-electrode space g (see description of Fig. 5 below). Preferred distance between substrate(s) 1 and side tabs 6 is less than 100 µm like for instance 50 µm. More in particular to avoid scratching the total thickness of the non-conductive material of the side tab 6 and substrate(s) 1 should be less than the free inter-electrode space g. Preferred smallest distance between substrate(s) 1 and side tabs 6 is less than 250 µm like for instance 100 or 50 µm.

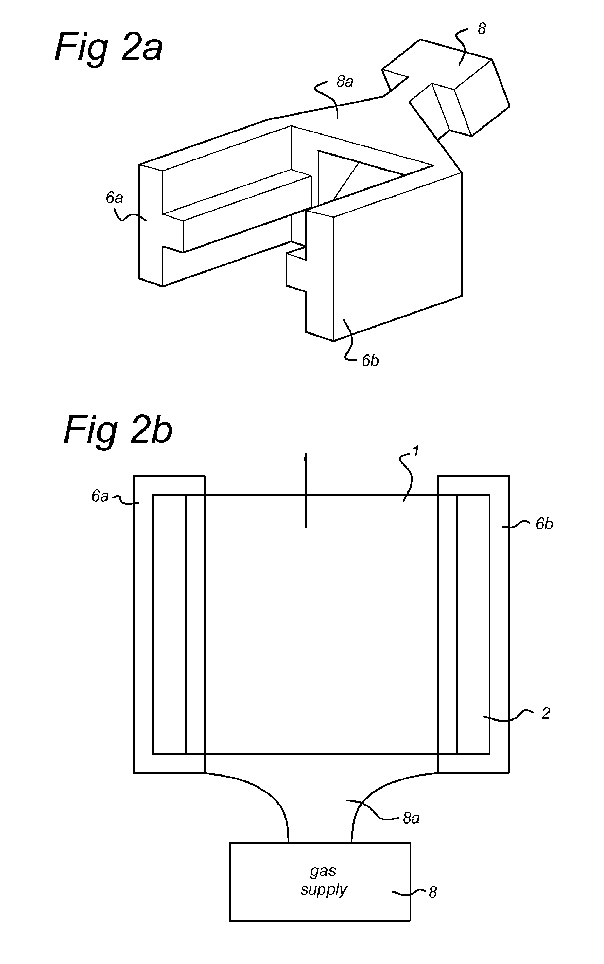

In a further embodiment (shown schematically in Fig.2) in the treatment space 5 two side tabs (6a,6b) are arranged at two opposing sides of the (rectangular) treatment space 5 in order to shield both sides of the treatment space 5 which is even more efficiently. Surprisingly it was observed that after installing two side tabs 6a, 6b in the treatment space 5 using a gas supply comprising precursor, the process efficiency for deposition on the substrate 1 is improved by about 60% without causing damages to the substrate 1. Examples show that about 60 % more deposition is observed after installing two side tabs 6a, 6b in the configuration as shown in Fig. 2. Another advantage is that risks of plasma break down at these side of the electrodes 2, 3 are minimized and thereby is lowering production risk.

Fig. 2a shows a three dimensional view of the combination of a gas supply inlet 8a which acts as a connecting element for the two side tabs 6a, 6b, the gas supply inlet 8a being connected to gas supply device 8. In another embodiment the at least one side tab 6 may be connected fixedly or is part of an integral unit also comprising the gas supply inlet 8a. The at least one side tab 6, 6a, 6b may alternatively be envisaged as fixed via a belt or loop and moving through the treatment space 5 and as such part of the plasma arrangement.

Fig. 2b shows a top view of the plasma treatment apparatus of the embodiment shown in Fig. 2. A possible movement direction of substrate 1 is indicated by the arrow. In this view it is shown that the two side tabs 6a, 6b protrude into the treatment space 5 (i.e. above electrode 2), even over the edge of substrate 1. Substrate 1 thus has a part which will be processed in operation, and a part at the side which is not processed. The two side tabs 6a, 6b, are connected to each other by the gas supply inlet 8a.A substrate 1 to be treated may be positioned in a fixed way or moving at a certain speed in the treatment space 5 close to one of the electrodes 2, 3. In embodiments of the invention the substrate 1 is a polymeric material moved through the treatment space or gap 5 and the side tab(s) 6, 6a, 6b is/are installed at the side position perpendicular on the substrate moving direction.

In another embodiment not one substrate 1 but two substrates (1a,1b) are positioned in a fixed way or moving at a certain speed in the treatment space 5 to utilise the gas supply even more efficiently. In Fig. 3 an example of such an embodiment comprising two side tabs 6a, 6b and two substrates 1a, 1b is shown.

Both electrodes 2, 3 can be provided with a dielectric barrier layer 2a, 3a (see the detailed schematic view as shown in Fig. 5). The dielectric layer 2a on the first electrode 2 has a thickness of d1 (mm), and the dielectric layer 3a on the second electrode 3 has a thickness of d2 (mm). In operation, the total dielectric distance d of the electrode configuration also includes the thickness of the (one or two) substrates 1a, 1b to be treated, indicated by f1 (mm) and f2 (mm) in Fig. 5. Thus, the total dielectric thickness of the dielectric barrier in the treatment space 5 between the at least two opposing electrodes (2, 3) equals d = d1+f1+f2+d2.

In a further embodiment, both d1 and d2 are 0 and the only dielectric material forming the dielectric barrier is the substrate 1a, 1b. In case of two substrates 1a and 1b, the total dielectric thickness in this case is d= f1 + f2.

In still another embodiment both d1 and d2 are 0 and only one substrate 1 is used. In this embodiment the total dielectric thickness equals f1, so d = f1. Also in this embodiment in which electrode 3 (See Fig.1) is not covered with a dielectric material it is possible to obtain a stable atmospheric glow discharge plasma.

The gap distance g in Fig. 5 indicates the smallest gap between the electrodes 2, 3 where an atmospheric pressure glow discharge plasma can exist in operation (i.e. in the treatment space 5), also called the free inter-electrode space. The dimensions of the electrodes 2, 3, dielectric barrier layers 2a, 3a, and gap g between the electrodes 2, 3, are predetermined in order to generate and sustain a glow discharge plasma at atmospheric pressure in the treatment space 5.

The dimensions of the electrodes 2, 3, dielectric barrier layers 2a, 3a, and gap g between the electrodes 2, 3 and the total dielectric distance (d) which is the total dielectric thickness of the dielectric barrier are controlled in a further embodiment, such that the product of gap distance and the total dielectric distance is arranged to be less than or equal to 1.0 mm² or even more preferred less than 0.5 mm². This is described in more detail in the not yet published European patent applications EP08151765.8, EP08165019.4 and EP08168741.0 of same applicant, which are herein incorporated by reference.

In general the atmospheric pressure plasma is generated between the two electrodes 2, 3 in order to be able to generate and sustain a glow discharge plasma at atmospheric pressure in the treatment space 5. Alternatively a plurality of electrodes 2, 3 is provided. In case the electrodes 2, 3 have a surface area which is at least as big as the substrate 1, the substrate 1 can be fixed in the treatment space 5 between the two electrodes 2, 3. In case the substrate 1 is larger than the electrode area, the substrate 1 may be moved through the treatment space 5, e.g. at a linear speed using a roll-to-roll configuration, an example of which is shown in the embodiment of Fig. 4. The substrates 1a, 1b are guided in close contact with the roller shaped electrodes 2, 3, using guiding rollers 9. The side tabs 6a, 6b are positioned at the roller end faces, thereby creating a closed off treatment space 5 between the electrodes 2, 3.

In the embodiments as described above, the power supply 4 can be a power supply providing a wide range of frequencies. For example, it can provide a low frequency (f= 10-500 kHz) electrical signal during the on-time. It can also provide a high frequency electrical signal for example f = 500 kHz - 30 MHz. Also other frequencies can be provided like from 450 kHz- 1 MHz or from 1 to 20 MHz and the like. The on-time may vary from very short, e.g. 20 µs, to short, e.g. 500 µs or as long as 2 minutes or continuous. The on-time effectively results in a pulse train having a series of sine wave periods at the operating frequency, with a total duration of the on-time. In deposition applications we surprisingly found, that by heating the substrate no visible indication of dust formation was observed not for the very short, e.g. 20 µs, or short, e.g. 500 µs and also not for periods as long as 2 minutes. In further deposition experiments, even 'continuous wave' applications of AC power by power supply 4 have been used. Good results have been obtained using a duty cycle of 90 % up to 100% and the most preferred embodiment for the plasma apparatus arrangement for this invention has no off-time at all.

Very good results can now be obtained by using an atmospheric pressure glow discharge (APG) plasma. Until recently these plasma's suffered from a bad stability, but using the stabilization circuits as for example described in US-6774569, EP-A-1383359, EP-A-1547123 and EP-A-1626613 (which are incorporated herein by reference), very stable APG plasma's can be obtained. In general these plasma's are stabilized by a stabilization circuit 21 (as shown Fig. 1, 2, and 3 ) counteracting local instabilities in the plasma. Using the stabilization circuit 21 in combination with the AC power source 20 in the power supply 4 for the plasma generating apparatus 10 results in a controlled and stable plasma, without streamers, filamentary discharges or other imperfections.

In one embodiment the apparatus of this invention including the stabilization circuit 21 is used to generate an atmospheric glow discharge plasma in a gas composition including a precursor for a compound or element to be deposited by which a single layer may be deposited. In another embodiment multiple layers of compound or element may be deposited by having multiple passes of the substrate 1 through the treatment space 5, or by having several treatment spaces 5 placed in line with each other. In this last embodiment layers of different composition can be applied over each other in a very efficient way, having a thickness of each layer of 1 nm or more.

The various embodiments of the plasma treatment apparatus as described above can be applied in various uses, like surface treatment, chemical or physical, cleaning, deposition and the like. Although oxygen as a reactive gas has a many advantages in for example surface modification uses or in uses where oxidative processes occur, also other reactive gases might be used like for example hydrogen, carbon dioxide, ammonia, oxides of nitrogen, and the like. In this invention, one or more carrier gasses are used chosen from the group comprising argon, nitrogen, or a combination of both. However, also other inert gasses (e.g. helium) or combinations of inert gasses may be used.

In another embodiment the substrate 1 is heated during the plasma treatment. By heating the substrate 1 slightly, e.g. by heating electrode 2, 3 slightly, it was surprisingly found that the dust formation was reduced, or even eliminated, while still obtaining good deposition results on the substrate 1. In order to raise the temperature various other embodiments may be used. Examples of such embodiments but are not limited thereto may be found in WO2008147184 from applicant, which is herein incorporated by reference.

When using the present plasma treatment apparatus for depositing material, the precursors supplied by the gas supply device 8 can be can be selected from (but are not limited to): W(CO)6, Ni(CO)4, Mo(CO)6, Co2(CO)8, Rh4(CO)I2, Re2(CO)i0, Cr(CO)6, or Ru3(CO)i2 , Tantalum Ethoxide (Ta(OC2Hs)s), Tetra Dimethyl amino Titanium (or TDMAT) SiH4 CH4 , B2H6 or BC13 , WF6 , TiCl4, GeH4, Ge2H6Si2H6 (GeH3)3SiH ,(GeH3)2SiH2. hexamethyldisiloxane (HMDSO), tetramethyldisiloxane (TMDSO), 1,1,3,3,5,5- hexamethyltrisiloxane, hexamethylcyclotetrasiloxane, octamethylcyclotetrasiloxane, decamethylcyclopentanesiloxane, tetraethoxysilane (TEOS), methyltrimethoxysilane, methyltriethoxysilane, dimethyldimethoxysilane, dimethyldiethoxysilane, trimethylethoxysilane, ethyltrimethoxysilane, ethyltriethoxysilane, n- propyltrimethoxysilane, n-propyltriethoxysilane, n-butyltrimethoxysilane, i- butyltrimethoxysilane, n-hexyltrimethoxysilane, phenyltrimethoxysilane, vinyltrimethoxysilane, vinyltriethoxysilane, aminomethyltrimethylsilane, dimethyldimethylaminosilane, dimethylaminotrimethylsilane, allylaminotrimethylsilane, diethylaminodimethylsilane, 1-trimethylsilylpyrrole, 1- trimethylsilylpyrrolidine, isopropylaminomethyltrimethylsilane, diethylaminotrimethylsilane, anilinotrimethylsilane, 2-piperidinoethyltrimethylsilane, 3 - butylaminopropyltrimethylsilane, 3 -piperidinopropyltrimethylsilane, bis(dimethylamino)methylsilane, 1 -trimethylsilylimidazole, bis(ethylamino)dimethylsilane, bis(butylamino)dimethylsilane, 2-aminoethylaminomethyldimethylphenylsilane, 3 -(4-methylpiperazinopropyl)trimethylsilane, dimethylphenylpiperazinomethylsilane, butyldimethyl-3-piperazinopropylsilane, dianilinodimethylsilane, bis(dimethylamino)diphenylsilane, 1,1,3,3-tetramethyldisilazane, 1 ,3-bis(chloromethyl)- 1,1,3,3 -tetramethyldisilazane, hexamethyldisilazane, 1 ,3-divinyl-1,1,3,3-tetramethyldisilazane, dibutyltin diacetate, aluminum isopropoxide, trimethylaluminium, triethyl aluminium, dimethoxymethyl aluminium, tris(2,4-pentadionato)aluminum, dibutyldiethoxytin, butyltin tris(2,4-pentanedionato), tetraethoxytin, methyltriethoxytin, diethyldiethoxytin, triisopropylethoxytin, ethylethoxytin, methylmethoxytin, isopropylisopropoxytin, tetrabutoxytin, diethoxytin, dimethoxytin, diisopropoxytin, dibutoxytin, dibutyryloxytin, diethyltin, tetrabutyltin, tin bis(2,4-pentanedionato), ethyltin acetoacetonato, ethoxytin (2,4-pentanedionato), dimethyltin (2,4-pentanedionato), diacetomethylacetatotin, diacetoxytin, dibutoxydiacetoxytin, diacetoxytin diacetoacetonato, tin hydride, tin dichloride, tin tetrachloride, triethoxytitanium, trimethoxytitanium, triisopropoxytitanium, tributoxytitanium, tetraethoxytitanium, tetraisopropoxytitanium, methyldimethoxytitanium, ethyltriethoxytitanium, methyltripropoxytitanium, triethyltitanium, triisopropyltitanium, tributyltitanium, tetraethyltitanium, tetraisopropyltitanium, tetrabutyltitanium, tetradimethylaminotitanium, dimethyltitanium di(2,4-pentanedionato), ethyltitanium tri(2,4-pentanedionato), titanium tris(2,4-pentanedionato), titanium tris(acetomethylacetato), triacetoxytitanium, dipropoxypropionyloxytitanium, dibutyryloxytitanium,monotitanium hydride, dititanium hydride, trichlorotitanium, tetrachlorotitanium, tetraethylsilane, tetramethylsilane, tetraisopropylsilane, tetrabutylsilane, tetraisopropoxysilane, diethylsilane di(2,4-pentanedionato), methyltriethoxysilane, ethyltriethoxysilane, silane tetrahydride, disilane hexahydride, tetrachlorosilane, methyltrichlorosilane, diethyldichlorosilane, isopropoxyaluminum, tris(2,4-pentanedionato)nickel, bis(2,4-pentanedionato)manganese, isopropoxyboron, tri-n-butoxyantimony, tri-n-butylantimony, di-n-butylbis(2,4-pentanedionato)tin, di-n-butyldiacetoxytin, di-t-butyldiacetoxytin, tetraisopropoxytin, zinc di(2,4-pentanedionate), diethylzinc, dimethylzinc and combinations thereof. Furthermore precursors can be used as for example described in EP-A- 1351321 or EP-A- 1371752. Generally the precursors are used in a concentration of 2-500 ppm e.g. around 50ppm of the total gas composition, but also concentrations over 500ppm can be used, for example 1000ppm, 2000ppm or 5000ppm and higher. The substrate 1, which should be treated or on which an (in)organic layer is deposited using the present method and apparatus maybe glass, ceramics or an organic polymer such as PEN or PET film. Also other types of substrates 1 may be used, e.g. PC (PolyCarbonate), COP (Cyclic Olefin Polymer), COC (Cyclic Olefin CoPolymer), etc.

### Experimental

Two PEN Q65 substrate rolls (100 µm thick) were simultaneously moved through a gap in the plasma surface treatment line as shown in Fig. 4 in a deposition process using 5 g/hr TEOS as precursor and 0.4 slm O₂ and 20 slm N₂ having two side tabs installed.

Side tabs 6a, 6b are made from PET and have a maximum thickness of 200 µm in the gap and are arranged like shown in the embodiment of Fig. 2a.

Typical process settings are: Power = 500W; frequency =166 kHz; gap distance/smallest free inter-electrode space = 0.5mm.
Substrate speed = 80 mm/min.
In order to control the stability of the APG plasma in the treatment space 5 a displacement current control was applied (dynamic matching).

The process efficiency is determined by the DR (dynamic rate) and the precursor flow. The DR is determined by the multiplication of layer thickness in nm and the foil speed during processing in m/min. The DR is expressed in nm*m/min. Fig. 6 gives the process efficiency as the relative DR per gram precursor flow.

Using two side tabs 6a, 6b we can reach a process efficiency of about 5, while by not using side tabs 6a, 6b the process efficiency is about 3. About 60% efficiency improvement is achieved by using the two side tabs as shown in Fig 6.

## Claims

1. Plasma treatment apparatus for treatment of a surface of a substrate, comprising a dielectric barrier discharge electrode structure having a treatment space (5) in between a first electrode (2) and a second electrode (3), and a power supply (4) connected to the first electrode (2) and the second electrode (3) for generating an atmospheric pressure plasma in the treatment space (5), the plasma treatment apparatus further comprising at least one side tab (6; 6a, 6b) in contact with an edge (11; 11a, 11b) of the first electrode (2) and an edge (12; 12a, 12b) of the second electrode (3), the at least one side tab (6; 6a, 6b) sealing off at least a part of the treatment space (5).

2. Plasma treatment apparatus according to claim 1, wherein the at least one side tab protrudes into the treatment space.

3. Plasma treatment apparatus according to claim 1 or 2, wherein the treatment space is a rectangular space, and the at least one side tab is positioned along at least one side of the treatment space.

4. Plasma treatment apparatus according to claim 1, 2 or 3, wherein the at least one side tab is provided at a side of the treatment space opposing a gas supply inlet for providing a gas mixture into the treatment space.

5. Plasma treatment apparatus according to any one of claim 1-4, wherein the at least one side tab comprises two side tabs provided at two opposing sides of the treatment space.

6. Plasma treatment apparatus according to claim 5, wherein the two side tabs are connected by a gas supply inlet for providing a gas mixture into the treatment space.

7. Plasma treatment apparatus according to any one of claims 1-6, wherein the at least one side tab comprises a non-conductive material.

8. Method for treatment of a substrate surface (1) using atmospheric pressure plasma, the method comprising:
providing a dielectric barrier discharge electrode structure for generating an atmospheric pressure plasma in a treatment space (5) between a first electrode (2) and a second electrode (3),
providing a substrate (1) in the treatment space,
applying a plasma generating power to the first and second electrode (2, 3), and
providing at least one side tab in contact with an edge of the first electrode and an edge of the second electrode, the at least one side tab sealing off at least a part of the treatment space (5).

9. Method according to claims 8, wherein the substrate is moved through the treatment space (5).

10. Method according to claim 8 or 9, wherein two substrates are moved simultaneously through the treatment space (5).

11. Method according to any one of claims 8-10, the substrate treatment comprising a chemical or physical surface treatment, a cleaning surface treatment or a surface deposition treatment.

12. Use of the method according to any one of claims 8-11 or use of the apparatus according to any of the claims 1-7 to obtain a treated substrate.
